# EUROPEAN PATENT SPECIFICATION

(11) **EP 3 119 176 B1**
(45) Date of publication and mention of the grant of the patent: **01.04.2020**
(21) Application number: 15749454.3
(22) Date of filing: 27.01.2015
(51) Int. Cl.: H05K 13/04, G05B 19/418, H05K 3/34, H05K 13/08

(54) **QUALITY MANAGEMENT APPARATUS, QUALITY MANAGEMENT METHOD AND PROGRAM**
QUALITÄTSMANAGEMENTVORRICHTUNG, QUALITÄTSMANAGEMENTVERFAHREN UND PROGRAMM
APPAREIL DE GESTION DE LA QUALITÉ, MÉTHODE DE GESTION DE LA QUALITÉ ET PROGRAMME

(30) Priority: 14.02.2014 JP 2014027000
(43) Date of publication of application: 18.01.2017
(73) Proprietor: Omron Corporation, Kyoto-shi, Kyoto 600-8530 (JP)
(72) Inventor: NISHI Takayuki, Kyoto-shi Kyoto 600-8530 (JP); MORI Hiroyuki, Kyoto-shi Kyoto 600-8530 (JP)
(74) Representative: Kilian Kilian & Partner
(86) International application number: PCT/JP2015/052208
(87) International publication number: WO 2015/122272

(56) References cited:
- EP-A1- 1 583 412
- JP-A- H06 286 105
- JP-A- 2005 116 597
- JP-A- 2007 235 018
- JP-A- 2008 199 070
- JP-A- 2009 071 137

## Description

### TECHNICAL FIELD

The present invention relates to technology for managing a surface mount production line.

### RELATED ART

Mounting onto printed circuit boards has been drastically improved due to the emergence of surface mount technology (SMT, also referred to as "planner mounting technology"), in which electronic components such as chip components are soldered directly onto the surface of printed circuit boards, as well as due to the downsizing of electronic components. In surface mount technology, solder in paste form (solder paste) is printed onto electrodes (lands) of printed circuit boards by using screen printing, electronic components are attached onto the printed circuited boards using a mounter, solder paste is heated and fused in a high-temperature furnace, which is usually called a "reflow furnace", and thus the electronic components are soldered onto the surface of the printed circuit boards.

In order to avoid stopping a surface mount production line, it is desired to predict the occurrence of failures, and to prevent the failures before it occurs. For example, Patent Document 1 discloses technology for predicting the occurrence of defective products based on analysis data regarding the quality state of facilities and circuit boards (work). Further, the EP 1 583 412 A1 discloses a mounting device for placing components on a circuit board. The mounting device heats up during operation and cools down afterwards, which negatively affects the placing accuracy. Therefore, the thermal expansion is determined by deviation from a reference mark and accordingly corrected. The JP 2007 235018 A also concerns with a position correction method of a mounting head in an electronic component mounter due to thermal expansion.

### RELATED ART DOCUMENTS

### PATENT DOCUMENTS

Patent Document 1: JP H08-18286A

### SUMMARY OF THE INVENTION

### PROBLEM TO BE SOLVED BY THE INVENTION

The quality state of a surface mount production line varies depending on the situation even if it is operated using the same parameters. For example, the quality state is likely to vary immediately after the line has been temporarily stopped and restarted in order to replace components of a manufacturing apparatus, adjust parameters, or suspend operations, for example. However, according to Patent Document 1, analysis is not performed with consideration of the above-described operation state of the line, and it is difficult to predict the occurrence of defective products while tracking changes in the operation state of the line.

The present invention is made in view of the above-described problems, and aims to provide technology for managing a surface mount production line according to the operation state of the surface mount production line, thereby reducing the possibility of failures occurring.

### MEANS FOR SOLVING THE PROBLEMS

The object of the present invention is achieved by an apparatus according to claim 1 and a method according to claim 10. Further advantageous embodiments of the invention are subject matters of dependent claims. Aspects of the invention are set out below. According to one aspect of the present invention, in order to solve the above-described problems, correction information for manufacturing apparatuses is learned based on the operation state of the surface mount production line, and setting parameters for the manufacturing apparatuses are corrected based on the state.

More specifically, one aspect of the present invention is a quality management apparatus for managing a surface mount production line for performing: a solder printing step of printing solder onto a printed circuit board by using a solder printing apparatus; a mounting step of arranging electronic components on the printed circuit board by using a mounter; and a reflow step of soldering the electronic components by using a reflow furnace. The quality management apparatus includes: state acquisition means for acquiring a state of the surface mount production line; correction information storage means for storing correction information for correcting a setting parameter for at least one of: the solder printing apparatus; the mounter; and the reflow furnace, for each state; and correction means for acquiring, from the correction information storage means, correction information that corresponds to the state acquired by the state acquisition means, and correcting the setting parameter for at least one of: the solder printing apparatus; the mounter; and the reflow furnace, using the acquired correction information.

It is likely that the same state causes the same quality variation. Therefore, it is possible to manufacture a product with reliable quality by correcting the setting parameters of the manufacturing apparatus based on the state.

According to this aspect of the present invention, the state is defined based on a cause of a stoppage of the surface mount production line in a case where the surface mount production line is stopped and restarted. For example, solder replacement, mask replacement, mask washing, squeegee replacement, circuit board receiver block replacement, and setting parameter change in the solder printing apparatus can be causes of a stoppage. Also, nozzle washing, nozzle replacement, feeder replacement, air pressure change, reference pin replacement, and a setting parameter change in the mounter can be causes of a stoppage. Also, thermocouple replacement, and temperature and other setting parameter change in the reflow furnace can be causes of a stoppage. Furthermore, examples of causes of a line stoppage include a simple stoppage (due to a lunch break or the like), during which component replacement or parameter change is not performed. Since the quality after a restart varies depending on the cause of the stoppage, it can also be defined as one state.

When defining the states according to this aspect of the present invention, the period of time since the restart of the surface mount production line is taken into consideration. For example, a predetermined period of time (one unit period of time) after solder replacement is defined as one situation, and each of the subsequent unit periods of time can be defined as one situation. This is because if the tendency of variation in the quality changes depending on the period of time elapsed since the restart, different states are defined in correspondence with different periods of time elapsed since the restart. Note that the time interval between states is not necessarily the same, and the time interval of each state may be freely determined.

It is preferable that this aspect of the present invention further includes learning means for learning correction information for correcting a setting parameter for at least one of: the solder printing apparatus; the mounter; and the reflow furnace, for each state, wherein the learning means is configured to operate the surface mount production line in a given state while changing the setting parameter, acquire an inspection result from an inspection apparatus for: the solder printing step; the mounting step; and the reflow step when operating the surface mount production line while changing the setting parameter, and determine correction information corresponding to the state based on the inspection result, and store the correction information in the correction information storage means.

In this way, it is possible to obtain appropriate correction information for each state by manufacturing a product by operating the surface mount production line in each state while actually changing the setting parameters for the manufacturing apparatuses, and learning the setting parameters that can achieve preferable inspection results (quality) for each state.

Any learning algorithm may be adopted for the learning means. For example, a learning logic such as a neural network, a support vector machine (SVM), or a boosting may be adopted.

The correction information according to this aspect of the present invention may be in any form as long as it can be used for converting setting parameters for a normal case to setting parameters for the respective states. For example, the correction information storage means may store correction information in the form of a correction function that converts setting parameters for a normal case to setting parameters for the respective states. Also, the correction information storage means can store correction information in the form of a table in which setting parameters for a normal case and setting parameters for the respective states are associated with each other.

In this aspect of the present invention, it is preferable that the learning means is configured to estimate correction information for a third state that relates to a first state and a second state, based on correction information for the first state and correction state for the second state, and to store the estimated correction information in the correction information storage means. For example, if correction information for the first state and the second state is known, correction information for the third state, which is a combination of the first state and the second state, can be estimated by interpolation. If correction information for the first state, and correction information for the second state, which is a combination of the first state and the third state, are known, correction information for the third state can be estimated by interpolation.

If this is the case, it is possible to accurately estimate correction information for states related to already-learnt states, based on the already-learnt states.

In this aspect of the present invention, the correction information storage means stores the correction information for each state for each component, and the correction means is configured to acquire correction information corresponding to a type of component from the correction information storage means, and to correct the setting parameter for at least one of: the solder printing apparatus; the mounter; and the reflow furnace.

If this is the case, it is possible to appropriately correct the setting parameters for the manufacturing apparatuses for each state and each component.

It is also preferable that the quality management apparatus further includes output means for outputting a value of the setting parameter that has been corrected or the amount of correction made to the setting parameter in a case where the correction means corrects the setting parameter. It is also preferable that the output means is configured to output a current state of the surface mount production line as well. Examples of the output means include, a display apparatus such as a display, a printing apparatus such as a printer, a sound output apparatus such as a speaker, and a message transmission apparatus that transmits messages such as mails and short messages.

If this is the case, the user can easily know what setting parameter has been corrected at the moment, and the reason for the correction (the current state).

It is also preferable that the correction means is configured to ask a user for a check before correcting the setting parameter, and correct the setting parameter after acquiring a permission from the user. At the time of checking the correction made to the setting parameter, it is preferable that a value of the setting parameter that has been corrected, the amount of correction made to the setting parameter as described above, and the current state of the surface mount production line is output.

In this aspect of the present invention, it is preferable that the correction means is configured to acquire a mount program for at least one of production facilities, which are the solder printing apparatus, the mounter, and the reflow furnace, and correct the setting parameters for at least one of the production facilities by correcting a portion of the mount program that relates to the setting parameters and transmitting the corrected mounting program to the corresponding production facility.

It is also preferable that this aspect of the present invention further includes notification means for providing a notification of a failure occurrence prediction if a difference between an inspection result of a work and a normal value is greater than or equal to a predetermined threshold in a case where the correction means corrects the setting parameter. Here, it is also preferable that the predetermined threshold is obtained by performing a correction information learning process.

By performing the learning process, it is possible to predict how the inspection result changes when the setting parameters for the manufacturing apparatuses in the respective states are changed. Therefore, if the inspection result of the work goes out of the range of prediction, it can be assumed that an unexpected situation has arisen and there is the possibility of failures.

Note that the present invention may be regarded as a quality management apparatus that includes at least some of the above-described means. The present invention can be regarded as a quality management method including at least some of the above-described steps, a computer program for causing a computer to execute the method, or a computer-readable recording medium on which the computer program is recorded. The above-described units or steps may be combined to the extent that technical inconsistencies do not arise.

### EFFECTS OF THE INVENTION

According to one aspect of the present invention, it is possible to reduce the possibility of failures, by managing the surface mount production line according to the operation state of the surface mount production line.

### BRIEF DESCRIPTION OF THE DRAWINGS

FIG. 1 is a schematic diagram showing an example of a configuration of production facilities and a quality management system.
FIG. 2(a) is a diagram showing a relationship between an operation state (scenes) and a quality of a mounting line.
FIG. 2(b) is a conceptual diagram showing a correction function for each scene.
FIG. 2(c) is a diagram showing the quality after setting parameters for each scene have been corrected.
FIG. 3 is a functional block diagram for a quality management system according to a first embodiment.
FIG. 4 is a flowchart showing a flow of learning processing.
FIG. 5 is a flowchart showing a flow of mount program correction processing.
FIG. 6 is a functional block diagram for a quality management system according to a second embodiment.
FIG. 7 is a flowchart showing a flow of inspection data monitoring processing.

### EMDODIMENTS OF THE INVENTION

The following provides a detailed description of exemplary modes for carrying out the present invention based on embodiments with reference to the drawings. However, the size, material, and shape of the constituent elements described in the embodiments, and the relative positions of the constituent elements, for example, are not intended to limit the scope of the present invention unless otherwise described.

### First Embodiment

### System Configuration

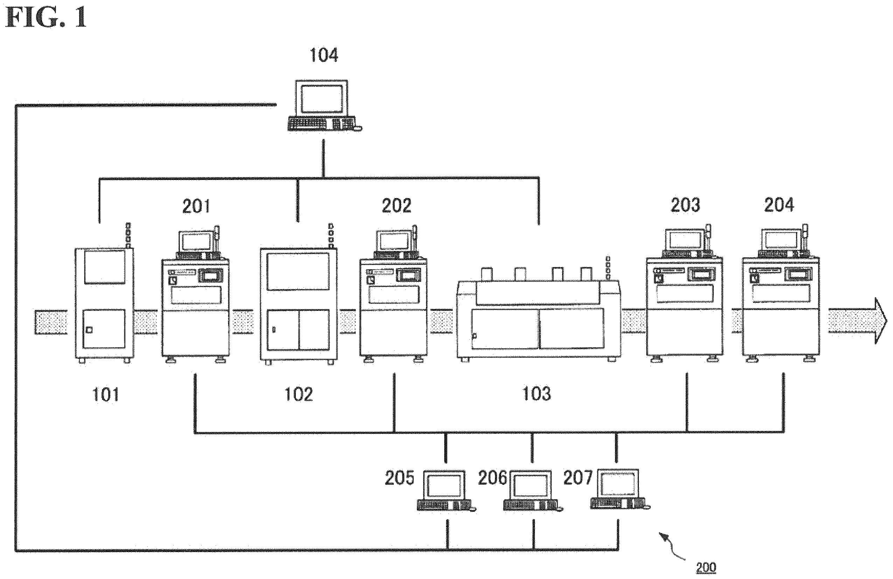

FIG. 1 schematically shows an example of a configuration of production facilities and a quality management system in a surface mount production line for printed circuit boards. Surface mount technology (SMT) is technology for soldering electronic components onto the surface of printed circuit boards, and the surface mount production line includes mainly three steps, namely solder printing, components mounting, and reflow soldering (solder fusing).

As shown in FIG. 1, the surface mount production line is provided with, from upstream to downstream, a solder printing apparatus 101, a mounter 102, and a reflow furnace 103, which are production facilities. The solder printing apparatus 101 is an apparatus that prints solder in paste form onto electrodes (which are referred to as "lands") on printed circuit boards by using screen printing. The mounter 102 is an apparatus for picking up electronic components that are to be mounted onto circuit boards, and placing the components onto the corresponding portions of solder paste, and is also referred to as a "chip mounter". The reflow furnace 103 is a heating apparatus for heating and fusing solder paste, then cooling the solder paste, thereby soldering the electronic components onto the circuit boards. The production facilities 101 to 103 are connected to a production facility management apparatus 104 via a network (LAN). The production facility management apparatus 104 is a system that performs management and overall control of the production facilities 101 to 103, and has the function of storing, managing, and outputting a mount program (including operational procedures, conditions for manufacturing, setting parameters, and so on) that define the operations of each production facility, and log data (including causes of a temporary stoppage of the line, a period of time elapsed since a restart, a circuit board ID, and so on) of each production facility. The production facility management apparatus 104 also has the function of updating the mount program that is set to the corresponding production facility upon receiving an instruction to change the mount program from an operator or another apparatus.

The surface mount production line is provided with a quality management system 200 that inspects the state of a circuit board at the exit of each of the steps of solder printing, components mounting, and reflow soldering, and automatically detects a failure or the possibility of a failure. The quality management system 200 automatically separates non-defective products from defective products, and also has the function of providing feedback that is based on the inspection results and the analysis results thereof to the operations of each production facility (e.g., the function of changing the mount program). As shown in FIG. 1, the quality management system 200 according to the present embodiment includes four types of inspection apparatuses, namely a solder printing inspection apparatus 201, a component inspection apparatus 202, an appearance inspection apparatus 203, and an X-ray inspection apparatus 204, an inspection management apparatus 205, an analysis apparatus 206, an operation terminal 207, and so on.

The solder printing inspection apparatus 201 is an apparatus for inspecting the printing state of solder paste on circuit boards conveyed from the solder printing apparatus 101. The solder printing inspection apparatus 201 performs two-dimensional or three-dimensional measurement of solder paste printed on circuit boards, and determines whether or not each of various inspection items has a normal value (within a permissible range) based on the results of measurement. Examples of the inspection items include, for example, the volume, area, height, degree of displacement, and shape of solder. An image sensor (a camera) can be used for two-dimensional measurement of solder paste, for example, and a laser displacement meter, a phase shifting method, a space encoding method, or a light-section method can be used for three-dimensional measurement, for example.

The component inspection apparatus 202 is an apparatus for inspecting the state of arrangement of electronic components on circuit boards conveyed from the mounter 102. The component inspection apparatus 202 two-dimensionally or three-dimensionally measures components (or portions of components, such as the main bodies of the components, or electrodes (leads)) that are placed on solder paste, and determines whether or not each of various inspection items has a normal value (within a permissible range) based on the results of measurement. Examples of the inspection items include, for example, positional displacement and angular (rotational) displacement of the components, missing components (components are not arranged), wrong components (i.e. incorrect components have been arranged), wrong polarity (i.e. the polarities of the electrodes on the components and the circuit board are incorrect), upside-down components (the components are arranged upside down), the height of the components, displacement of the electrodes, and raised electrodes. Similar to solder printing inspection, an image sensor (a camera) can be used for two-dimensional measurement of electronic components, for example, and a laser displacement meter, a phase shifting method, a space encoding method, or a light-section method, can be used for three-dimensional measurement, for example.

The appearance inspection apparatus 203 is an apparatus for inspecting the state of soldering on circuit boards conveyed from the reflow furnace 103. The appearance inspection apparatus 203 performs two-dimensional or three-dimensional measurement of solder portions that have been subjected to reflow soldering, and determines whether or not each of various inspection items has a normal value (within a permissible range) based on the results of measurement. Examples of the inspection items include, for example, the condition of the shape of solder fillets, in addition to the items for component inspection. For measurement of the shape of solder, a so-called color highlight method (i.e., a method in which a solder surface is irradiated with R, G, and B light rays at different incident angles, images of the reflected light rays having the respective colors are captured using a vertical camera, and thus the three-dimensional shape of solder is detected as two-dimensional hue information) may be used instead of the laser displacement meter, the phase shifting method, the space encoding method, and the light-section method described above, for example.

The X-ray inspection apparatus 204 is an apparatus for inspecting the state of soldering on circuit boards by using an X-ray image. For example, in the case of packaged components or multi-layer circuit boards, such as a ball grid array (BGA) or a chip size package (CSP), solder joints are hidden under the components or the circuit boards, and it is impossible to inspect the state of solder by using the appearance inspection apparatus 203 (i.e., by using an image of the external appearance). The X-ray inspection apparatus 204 is an apparatus that complements such shortcomings of external appearance inspection. Examples of the inspection items for the X-ray inspection apparatus 204 include, for example, the positional displacement of the components, the solder height, the solder volume, the solder ball diameter, the length of back fillets, and the condition of solder joints. Note that an X-ray transmission image may be used as an X-ray image, and the use of a computed tomography (CT) image is also preferable.

These inspection apparatuses 201 to 204 are connected to the inspection management apparatus 205 via a network (LAN). The inspection management apparatus 205 is a system that performs management and overall control of the inspection apparatuses 201 to 204, and has the function of storing, managing, and outputting an inspection program (including inspection procedures, conditions for inspections, setting parameters, and so on) that define the operations of the inspection apparatuses 201 to 204, and inspection results and log data acquired by the inspection apparatuses 201 to 204.

The analysis apparatus 206 is a system that has, for example, the function of predicting failures and estimating causes of the failure by analysing the inspection results of the inspection apparatuses 201 to 204 (inspection results of each step) collected in the inspection management apparatus 205, and the function of providing feedback to the production facilities 101 to 103 (e.g., the function of changing the mount program) as appropriate.

The operation terminal 207 is a system that has, for example, the function of displaying information such as the state of the production facilities 101 to 103, the inspection results of the inspection apparatuses 201 to 204, and the analysis results of the analysis apparatus 206, the function of changing (editing) the mount program and the inspection programs in the production facility management apparatus 105 and the inspection management apparatus 205, and the function of checking the operation state of the whole surface mount production line.

The production facility management apparatus 104, the inspection management apparatus 205, and the analysis apparatus 206 each can be configured with a general-purpose computer system provided with, for example, a CPU (a central processing unit), a main storage apparatus (a memory), an auxiliary storage apparatus (a hard disk or the like), input apparatuses (a keyboard, a mouse, a controller, a touch panel, and the like), and a display apparatus. Although the apparatuses 104, 205, and 206 may be separate apparatuses, it is possible to implement all the functions of the apparatuses 104, 205, and 206 onto a single computer system, and it is also possible to implement all or some of the functions of the apparatuses 104, 205, and 206 onto a computer provided in any of the production facilities 101 to 103 and the inspection apparatuses 201 to 204. In addition, although the network for the production facilities and the network for the quality management system are separated from each other, any network configuration may be adopted insofar as mutual data communication is available.

### Overview of Quality Management System

The following provides a further detailed description of the quality management system according to the present embodiment. The quality management system according to the present embodiment takes the operation state (scenes) of the mount line into consideration, and dynamically changes the setting parameters for the production facilities 101 to 103 for each scene, thereby preventing failures from occurring and the mount line from being stopped.

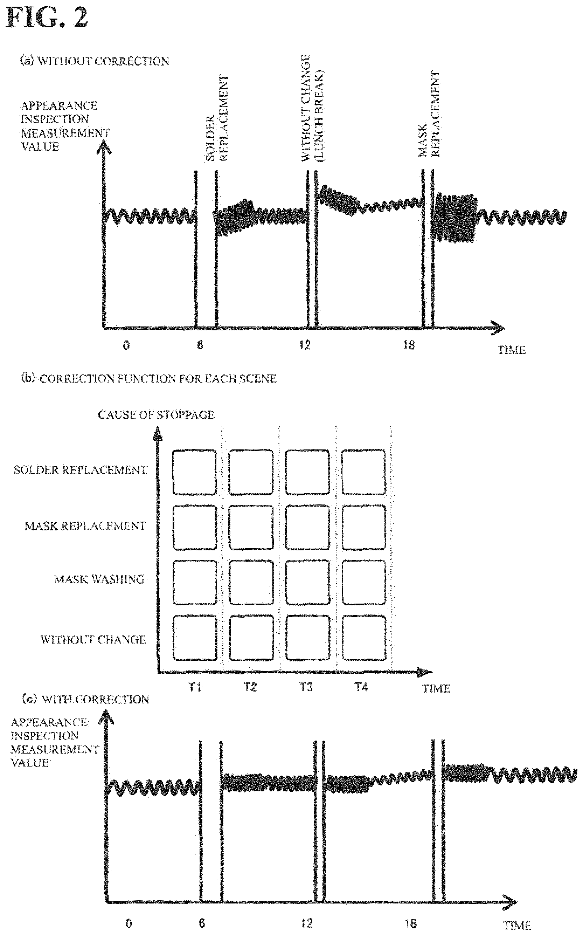

First, a description is given of the operation state (scenes) of the mount line. FIG. 2(a) is a conceptual diagram showing the relationship between the operation state of the mount line and the quality (the inspection results). The mount line can be temporarily stopped for various reasons such as replacement of components and parameter adjustment. For example, solder replacement of the solder printing apparatus 101, nozzle replacement in the mounter 102, and thermocouple replacement of the reflow furnace 103 can be a cause of a temporary stoppage of the mount line. Immediately after solder for the solder printing apparatus 101 has been replaced, the quality of solder printing (solder printing amount) varies because solder is hard, for example, even if solder printing is performed using the setting parameters that are the same as those for a normal case. Similarly, immediately after a suction nozzle of the mounter 1.02 has been replaced, the quality of component attachment (the positions of the components, the push-in amount, and so on) varies even if component attachment is performed using setting parameters that are the same as those for a normal case. Immediately after a thermocouple of the reflow furnace 103 has been replaced, the quality of solder joints (the shape of fillets, the positions of the electrodes, and so on) varies. Also, variations occur in the quality after a component other than solder and the nozzle has been replaced, and even without component replacement, variations occur after the line has been temporarily stopped during a lunch break or the like.

The tendency of variations in the quality after a restart depends on the cause of a temporary stoppage of the mount line. Therefore, by defining scenes for different causes of a temporary stoppage of the mount line, it is possible to obtain a method for correcting the setting parameters for the manufacturing apparatuses to achieve reliable product quality for each scene. Therefore, in the quality management system according to the present embodiment, as shown in FIG. 2(b), a scene is defined for each cause of a temporary stoppage and operation time from a restart (each square in the drawing represents one scene), and correction functions (correction information) for correcting the setting parameters for the production facilities are created and stored in advance.

It is possible to achieve reliable product quality as shown in FIG. 2(c) by correcting the setting parameters using the respective correction functions for the scenes shown in FIG. 2(b). Note that if the product quality varies after a restart, even if this variation does not solely lead to the determination that a failure has occurred, the possibility of a failure occurring increases due to other concurrent factors. Therefore, even if quality variation after a restart is not as significant as leading to the determination that a failure has occurred, it is preferable to remove such quality variation as much as possible.

### Configurations

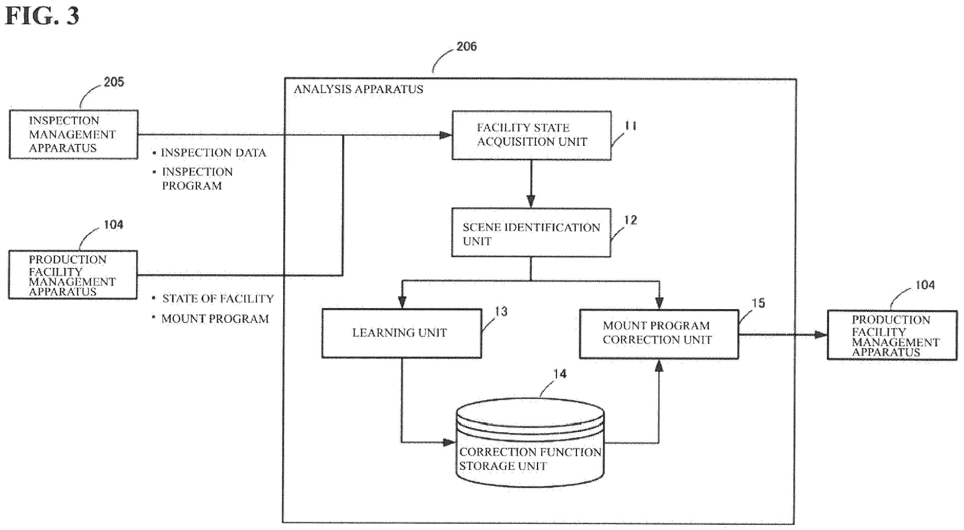

FIG. 3 is a functional block diagram for the quality management system according to the present embodiment. As shown in the drawing, the quality management system according to the present embodiment includes a facility state acquisition unit 11, a scene identification unit 12, a learning unit 13, a correction function storage unit 14, and a mount program correction unit 15. It is assumed that these functional blocks are realized by a computer executing a program in the analysis apparatus 206. Note that the functions shown in FIG. 3 may also be realized in another apparatus in the quality management system 200. Note that FIG. 3 only shows the functional blocks for realizing the above-described functions, and other functions for performing the quality management of the surface mount production line are omitted.

The facility state acquisition unit 11 acquires various kinds of information regarding the state of the mount line from the production facility management apparatus 104 and the inspection management apparatus 205. For example, the facility state acquisition unit 11 acquires log data and mount programs for the production facilities from the production facility management apparatus 104. The log data includes causes of the previous stoppage of the mount line, and operation time elapsed since a restart (or a time at which the operation is restarted). The facility state acquisition unit 11 also acquires inspection data (inspection results) acquired by the inspection apparatuses, and inspection programs for the inspection apparatuses from the inspection management apparatus 205.

The scene identification unit 12 determines the current operation state (scene) of the mount line based on the information acquired by the facility state acquisition unit 11, in particular the cause of the previous stoppage of the mount line and operation time elapsed since the restart. Scenes of the mount line are defined by causes of the temporary stoppage and a period of time elapsed since the restart. The scene identification unit 12 corresponds to state acquisition means according to one aspect of the present invention.

The correspondence between causes of a temporary stoppage and scenes may be defined in advance. For example, scenes can be defined in correspondence with causes of a stoppage such as solder replacement, mask replacement, mask washing, squeegee replacement, circuit board receiver block replacement, and setting parameter change in the solder printing apparatus 101. Also, scenes can be defined in correspondence with nozzle washing, nozzle replacement, feeder replacement, air pressure change, reference pin replacement, and a setting parameter change in the mounter 102. Also, scenes can be defined in correspondence with thermocouple replacement, and temperature and other setting parameter change in the reflow furnace. Even a temporary stoppage due to a reason other than checking (due to a lunch break or the like), during which component replacement or the like is not performed, can also be defined as one scene, and such temporary stoppages can be defined as different scenes based on the durations of the temporary stoppages. Also, if there are combinations of the above-described causes, a scene can be defined for each combination of causes. For example, when solder replacement and nozzle replacement are simultaneously performed, it is preferable that a scene that is different from the scene of solder replacement and the scene of nozzle replacement is defined.

Separate scenes are defined depending on the period of time elapsed since the restart. For example, even if the cause of a temporary stoppage is the same, a new scene is defined every time a predetermined period of time elapses since the restart. Preferably, this time interval has a length that makes it possible to assume that the tendency of variations in the product quality within the interval is substantially the same. For example, a period of fifteen minutes is defined as the predetermined period of time (unit time), and a period from a point in time immediately after the restart to fifteen minutes after the restart, a period from fifteen minutes after the restart to thirty minutes after the restart, a period from thirty minutes after the restart to forty-five minutes after the restart, and a period from forty-five minutes after the restart to sixty minutes after the restart, are each defined as one scene. Although the time interval here is assumed to be constant, the time interval is not necessarily constant, and may be increased as operation time increases, for example. Also, a different time interval may be defined for each cause of stoppage.

The learning unit 13 learns a method for correcting the settings parameters for the manufacturing apparatus to reliably maintain the product quality for each scene, and stores the setting parameters in the correction function storage unit 14. The setting parameters to be corrected can be selected for each scene. For example, the printing position of solder, the amount of solder, the printing pressure, the printer speed and so on for the solder printing apparatus, the component suction position, the component attaching position, the push-in amount, the attaching speed and so on for the mounter, and the temperature and the time for the reflow furnace can be corrected.

The correction function storage unit (correction information storage means) 14 stores correction information for obtaining corrected setting parameters used for a relevant scene from the values of setting parameters for a normal case. In the present embodiment, the correction information is stored in the form of correction functions. The correction functions may be linear equations, quadratic equations, or other given functions. The correction information may be stored in the form of a table instead of the functions insofar as the values of corrected setting parameters can be acquired from the values of settings parameters for a normal case. The details of learning processing (the method for generating the correction information) will be described later.

The mount program correction unit 15 refers to the correction function storage unit 14, and corrects the setting parameters for the production facility according to the current scene of the mount line. The mount program correction unit 15 acquires a mount program from the production facility management apparatus 104, corrects the setting parameters in the mount program based on a correction function, and transmits the corrected mount program to the production facility management apparatus 104. Since the production facility management apparatus 104 controls the production facilities based on the mount program including the corrected setting parameters, the production facilities operate according to the corrected setting parameters. The details of correction processing will be described later.

Note that learning processing by the learning unit 13 and the mount program (setting parameters) correction processing by the mount program correction unit 15 are not simultaneously performed. The learning processing is performed first, and then, upon completion of learning, the learning processing is stopped and the mount program correction processing is performed.

### Learning Processing

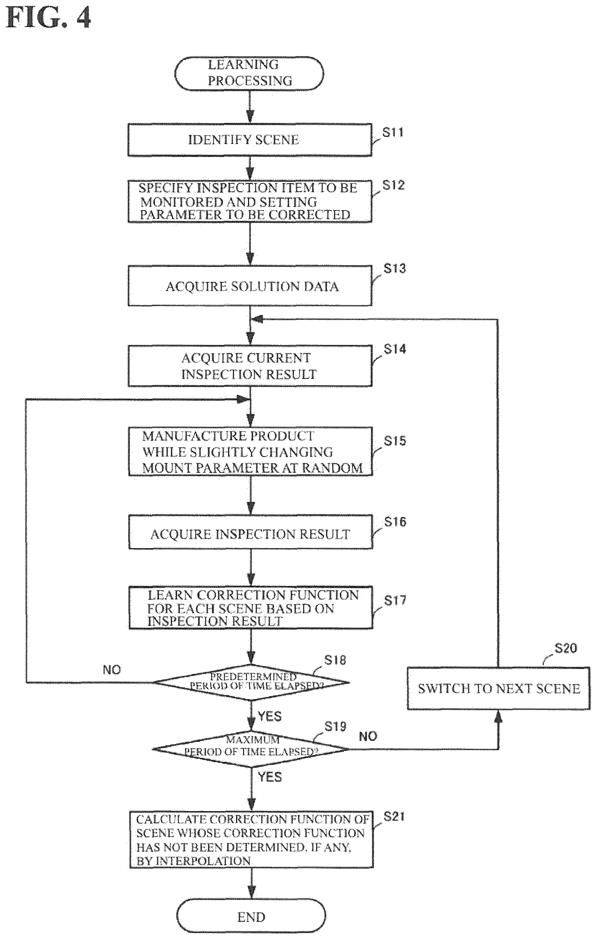

With reference to the flow chart shown in FIG. 4, the following describes further details of learning processing performed by the learning unit 13 when the quality management system according to the present embodiment is going through a learning phase. In the following description, a case in which solder in the solder printing apparatus has been replaced is described as a specific example. However, note that the flowchart shown in FIG. 4 is applicable to any given state.

First, the scene identification unit 12 identifies the current scene of the mount line based on information regarding the production facilities, the information being acquired by the facility state acquisition unit 11 (S11). When the mount line is temporarily stopped due to a cause such as component replacement, information indicating which component has been replaced is transmitted from the production facility to the production facility management apparatus 104, and this information is acquired by the facility state acquisition unit 11. For example, information indicating that solder in the solder printing apparatus 101 has been replaced is input from the production facility management apparatus 104 to the facility state acquisition unit 11. Information indicating which component has been replaced may be input by the user to the operation terminal 207, and may be acquired by the facility state acquisition unit 11 from the operation terminal 207. The log data of each production facility includes the period of time elapsed since the restart, the ID of the circuit board that is currently being processed, and so on. The scene identification unit 12 specifies the current scene based on such a cause of the temporary stoppage of the mount line and the period of time elapsed since the restart.

Next, the learning unit 13 specifies the inspection items that are to be monitored and the setting parameters that are to be corrected, in correspondence with the scene (S12). For example, the volume of solder varies after solder is replaced, and therefore the appearance inspection apparatus 203 monitors the inspection item regarding the volume of solder, and determines the printing pressure of the solder printing apparatus 101 as a setting parameter to be corrected. For each scene, which inspection item and which setting parameter should be focused on may be input by the user in advance in association with the scene. In the following description, it is assumed that one inspection item and one setting parameter are associated with a scene. However, with respect to a scene, there may be a plurality of inspection items to be monitored and a plurality of setting parameters to be corrected.

Typically, a plurality of components are mounted on one circuit board, and it is desirable that the setting parameters for the production facilities are optimized for each component. Therefore, the learning unit 13 simultaneously performs the processing in steps S13 to S17 described below for respective components that are to be mounted on the circuit board that is being processed. Note that if the setting parameter does not vary between components, and the setting parameter is the same in the same circuit board, it is acceptable to perform the following processing without distinguishing the components from each other.

First, the learning unit 13 acquires an appropriate measurement value (correct solution data (or target data)) of an inspection item (S13). The learning unit 13 can acquire the correct solution data by referring to an inspection program of an inspection apparatus, acquired by the inspection management apparatus 205 (in the above-described example, the inspection program of the appearance inspection apparatus 203).

Next, the learning unit 13 acquires the inspection result in the case where manufacturing is performed using the setting parameter corrected according to the correction function at the time (S14). As described below, the correction function storage unit 14 is updated along with the progress of learning processing, and learning processing is repeated over a plurality of days. Therefore, the inspection result that can be achieved using the correction function at the time is checked in this step. Note that before learning processing is started, the correction function is initialized so as to represent the absence of correction (the input to and the output from the correction function are the same).

In step S14, although it is acceptable that only the inspection result that can be acquired by manufacturing a product once (the inspection result that can be acquired from one circuit board) is acquired, the average or variance of the inspection results that can be acquired by manufacturing a product a plurality of times (the inspection results that can be acquired from a plurality of circuit boards) may be acquired as well. It is possible to remove the influence of variations in each instance of product manufacturing by applying statistical processing to a plurality of inspection results.

Next, the learning unit 13 slightly changes, at random, the parameter to be corrected, for the production facility, and a product is manufactured using the setting parameter thus changed (S15). For example, a product is manufactured while the printing pressure of the solder printing apparatus 101 is slightly changed at random from the value corrected according to the current correction function. In order to manufacture a product while changing the setting parameter, the mount program of the manufacturing facility is changed in the analysis apparatus 205, and the mount program thus changed is passed to the production facility via the production facility management apparatus 104.

Upon the mount program being changed, a product is manufactured using the setting parameter thus changed, and the inspection apparatus inspects the product. The learning unit 13 acquires the inspection result of the product manufactured using the setting parameter thus changed, from the inspection management apparatus 205 (S16). The inspection item acquired in this step is the same as the inspection item acquired in step S14, and it is preferable that the average or variance of inspection results is acquired by manufacturing a product a plurality of times.

The learning unit 13 learns the correction function for an individual scene based on the inspection result acquired in step S16 (S17). Specifically, if the inspection result acquired in step S16 shows an improvement from the inspection result acquired in step S14 (i.e., is closer to the correct solution data), the parameter correction made in step S15 is regarded as being effective, and the correction function is updated. In contrast, if the inspection result acquired in step S16 does not show an improvement from the inspection result acquired in step S14, the correction function is not updated.

Next, the learning unit 13 determines whether or not the duration time of a scene (a predetermined period of time) has elapsed since the start of the each scene (S18). For example, a period of fifteen minutes may be adopted as the duration time of one scene. If the period of time elapsed since the start of the scene is shorter than or equal to the duration time (S18-NO), the learning unit 13 determines that the same scene is continuing, and the processing in steps S15 to S18 is repeated. If a period of time that is longer than or equal to the duration time of the scene has elapsed (S18-YES), the learning unit 13 determines whether or not the period of time elapsed since the restart of the mount line has exceeded maximum time allowed for parameter correction (S19). This maximum time is the maximum period of time during which quality variation might occur due to the stoppage of the mount line, and has been set in advance. For example, a period of sixty minutes may be adopted. If the period of time elapsed since the restart of the mount line has not exceeded the maximum time (S19-NO), the learning unit 13 ends the current scene and transitions to the next scene (S20). For example, the learning unit 13 transitions from a scene indicating "solder replacement, zero to fifteen minutes has elapsed since the restart" to a scene indicating "solder replacement, fifteen to thirty minutes has elapsed since the restart".

After the scene transition, the learning unit 13 returns to step S14 and repeats the same processing as described above. Since the correct solution data does not vary between scenes, the learning unit 13 returns to step S14. However, if the correct solution data varies between scenes, the learning unit 13 may return to step S13.

If the period of time elapsed since the restart of the mount line has exceeded the maximum time (S19-YES), the learning unit 13 temporarily ends learning processing that has been performed since the restart. At this time, if the correction function storage unit 14 has a scene whose correction function has not been determined, it is preferable that the correction function is obtained by interpolation using another scene (S21). For example, in the case where there are the correction function for the scene after solder replacement and the correction function for the scene of solder replacement and mask replacement, but there is no correction function for the scene of mask replacement, the correction function for the scene of mask replacement may be estimated based on the difference between the aforementioned two correction functions. In the case where there are the correction function for the scene after solder replacement and the correction function for the scene of mask replacement, but there is no correction function for the scene of solder replacement and mask replacement, the correction function for the scene of solder replacement and mask replacement may be estimated based on the sum of the aforementioned two correction functions.

Thus, learning processing that has been performed since the restart of the mount line temporarily ends. This learning processing is repeated each time the mount line is restarted. Note that if learning processing for the same scene has been previously performed, learning may be continued based on the previous learning results. The accuracy of the correction function is improved by repeatedly performing learning.

Note that when a given cause of a stoppage is learned for the first time, learning is performed such that, for the first period (e.g. within fifteen minutes after the restart), a function that does not perform correction (output = input) is used as the initial value of the correction function, and for the next period (e.g. fifteen minutes to thirty minutes after the restart, the learning result of the first period is used as the initial value. This is because it can be assumed that the correction function for the second period is similar to the correction function for the first period, and the learning speed thus improves.

Learning processing needs to be performed for a certain period of time. For example, learning may be ended when the correction function has sufficiently converged (when the amount of changes in the correction function is smaller than or equal to a predetermined amount). Alternatively, learning may be ended when a predetermined period of time (e.g. one week) has elapsed. After learning processing has been ended, further learning is not performed, and correction by the mount program correction unit 15 becomes effective.

In the description above, the changing of the setting parameter and learning processing are repeated within a single period. However, this is not essential. For example, it is acceptable that manufacturing and inspection are performed while changing the setting parameter a plurality of times within a period, and then learning is performed regarding correction made to the setting parameter based on the changes in the setting parameter and the inspection results.

The above-described learning method is merely an example, and a learning method for obtaining appropriate setting parameters for each scene is not limited to the above-described method. Any existing method such as a method using a neural network, a support vector machine (SVM), or boosting may be adopted as a learning algorithm.

### Mount Program Correction Processing

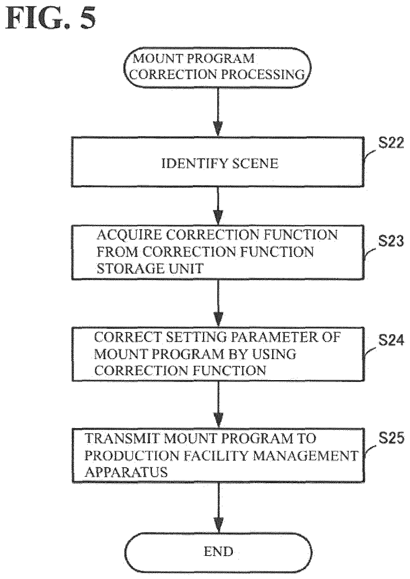

With reference to the flow chart shown in FIG. 5, the following describes further details of correction processing performed by the mount program correction unit 15 when the quality management system according to the present embodiment is going through a correction phase. In the following description, a specific case in which solder in the solder printing apparatus has been replaced is described. However, note that the flowchart shown in FIG. 5 is applicable to any given state.

First, the scene identification unit 12 identifies the current scene of the mount line based on information regarding the production facilities, the information being acquired by the facility state acquisition unit 11 (S22). Since this processing is basically the same as step S11 of the learning phase, a detailed description is omitted.

Upon a scene being specified, the mount program correction unit 15 acquires the correction function that corresponds to the scene, from the correction function storage unit 14 (S23). Then, the mount program correction unit 15 corrects a mount program of a production facility by correcting the setting parameter to be corrected (e.g. the printing pressure of the solder printing apparatus), using the acquired correction function (S24). For example, in the case where it is originally stated in the mount program that printing is to be performed at a printing pressure P, the mount program correction unit 15 changes the mount program so that printing is performed at a printing pressure P' resulting from the application of the correction function. The mount program correction unit 15 transmits the corrected mount program to the production facility management apparatus 104 (S25), and the production facility management apparatus 104 operates the production facility using the corrected mount program. Consequently, a product is manufactured using an appropriate setting parameter depending on the scene, and the quality of the product becomes reliable.

The scene is switched to another when a predetermined period of time has elapsed since the restart of the mount line. Therefore, the above-described processing is repeated upon the scene being changed. The influence of the stoppage of the line gradually decreases after the restart of the mount line. However, it is possible to always manufacture a desirable product by changing the degree of a change in the setting parameters depending on the scene.

When correcting the mount program, it is preferable that the current scene, the corrected setting parameter item, the value of the setting parameter after correction, the amount of correction, etc., are output to the operation terminal 207 and so on. This is for the purpose of allowing the user to easily know what setting parameter has been corrected, why the correction has been made, and so on. Although the mount program may be automatically corrected, it is also preferable that the mount program is corrected after the user's permission has been given. For example, it is acceptable to ask the user about whether or not to correct the mount program via the operation terminal 207 while notifying the user of the current scene, the setting parameter item to be corrected, the value of the setting parameter after correction, the amount of correction, etc., and reflect the correction made to the mount program only when user inputs a permission for correction.

### Advantageous Effects of Present Embodiment

With the quality management system according to the present embodiment, it is possible to minimize variations in the product quality due to a stoppage of the mount line by defining scenes (operation states) based on the cause of the stoppage of the mount line and the period of time elapsed since the restart, and adjusting the setting parameters for the production facilities for the respective scenes. Causes of a stoppage of the mount line include, for example, replacement of a component of a production facility, parameter adjustment, and a mere stoppage of the line (without replacement of a component). The state of the mount line after a restart is different from that in a normal case depending on the respective causes, and the product quality varies. Even if the variation per se is within the permissible range of a failure determination, it is likely that the variation goes beyond the range of a non-defective product when an unexpected variation is added. Therefore, it is preferable to suppress such a variation as well as much as possible. According to the present embodiment, it is possible to achieve reliable product quality by learning a method for correcting the setting parameters for achieving reliable quality for each scene, and manufacturing a product by adjusting the setting parameters according to the results of learning.

### Second Embodiment

According to the second embodiment, the setting parameters for the respective scenes are corrected, and monitoring is performed to check whether or not the results of inspection after the setting parameters have been corrected are the expected results. In learning processing, it is possible to obtain the results of inspection in the case where a product is manufactured after the setting parameters for the respective scenes have been corrected. That is, it is possible to know beforehand the inspection results when a product is manufactured after the setting parameters for the respective scenes have been corrected. If the inspection results are out of the range, it is possible to determine that an unexpected situation has happened and a failure is likely to occur.

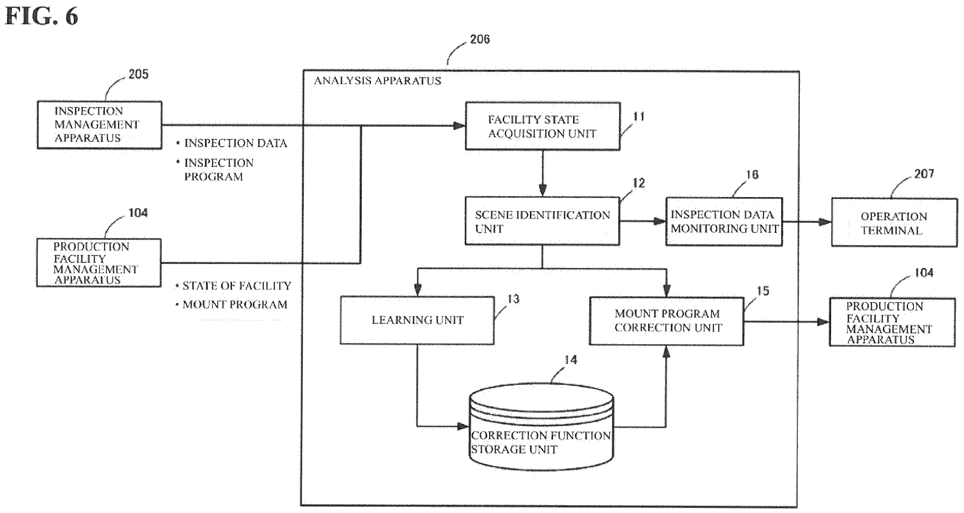

FIG. 6 is a diagram showing a functional block of a quality management system according to the present embodiment. The difference from the first embodiment (FIG. 3) is that an inspection data monitoring unit 16 is provided. The following mainly describes the inspection data monitoring unit 16.

During learning processing, a product is actually manufactured while the setting parameters for respective scenes are changed, and the correction function for the setting parameters is obtained based on the inspection results. Since a product is manufactured and inspected a plurality of times, it is possible to know, for each scene, the tendency of the inspection results in the case where the correction that is the same as the correction using the final correction function has been made (the range of normal values of the inspection results). Here, examples of the tendency of the inspection results include, in addition to measurement values of the inspection results, statistics of the measurement values, such as the variance, the maximum, and the minimum of the measurement values. That is, it is possible to know the values that the inspection results should take (which basically match the correct solution data), the variance of the inspection results, and so on when a product is manufactured using the ultimate correction function. The learning unit 13 obtains and stores the range of normal values of the inspection results, for each scene and each component. The inspection data monitoring unit 16 predicts the occurrence of a failure in the mount line based on the normal values of the inspection results for the respective scenes.

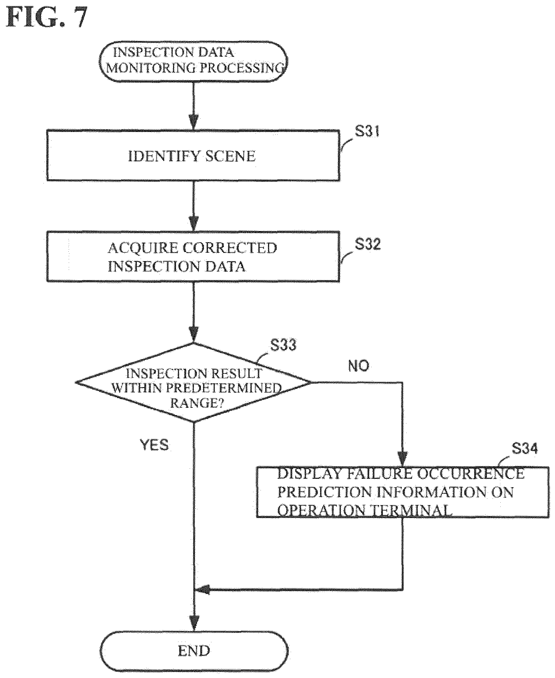

FIG. 7 is a flowchart relating to prediction of the occurrence of a failure in the quality management system according to the present embodiment. First, the scene identification unit 12 identifies the current scene of the mount line based on information regarding the production facilities, the information being acquired by the facility state acquisition unit 11 (S31). The mount program of the production facility is corrected based on the scene, and a product is manufactured. The inspection data monitoring unit 16 acquires the inspection data of the product manufactured using the corrected mount program (S32). In this regard, the average, the variance, the maximum, the minimum, or the like of the inspection data is obtained. The inspection data monitoring unit 16 determines whether or not the acquired inspection data is within the range of normal value of the inspection result obtained through learning processing (S33). If the inspection data is within the range of normal value (S33-YES), it can be determined that manufacturing is being performed as expected. If the acquired inspection data is out of the range of normal value of the inspection data (S33-NO), it can be assumed that an unexpected situation has arisen, and it is determined that if manufacturing is continued in the same situation, there is the possibility of a failure occurring. Therefore, the inspection data monitoring unit 16 outputs prediction information indicating that possibility that a failure occurs, to the operation terminal 207 (S34). The user can prevent a failure from occurring, by performing a check based on the notification.

### Modifications

The embodiments above merely describes the present invention in an illustrative manner, and the present invention is not limited to the above-described specific embodiments. The present invention may be variously modified within the scope of the technical concept of the present invention.

In the description above, a description is given on the assumption that only one setting parameter is corrected. However, the number of setting parameters to be corrected for each scene may be one or more. In the case of correcting a plurality of setting parameters, they may be setting parameters for the same production facility, or those for setting parameters for different production facilities.

In the description above, an example in which the inspection item is the solder volume, and the printing pressure is corrected with respect to the scene (the cause of a stoppage) of solder replacement has been described. However, a plurality of scene can be defined for respective causes of a stoppage of the mount line. For example, nozzle replacement of the mounter, thermocouple replacement of the reflow furnace, and so on may each be defined as one scene. Regarding the scene of nozzle replacement of the mounter, the setting parameters for the mounting position and the head movement speed of the mounter may be changed based on the inspection item such as component displacement of the component inspection apparatus, for example. Regarding the scene of thermocouple replacement of the reflow furnace, the setting parameters for the reflow furnace temperature and the conveyor speed may be changed based on the inspection items such as the shape of fillets and displacement of the electrodes with respect to the appearance inspection and the X-ray inspection, for example. Also, setting parameters for a plurality of production facilities may be changed with respect to one scene.

In the description above, the scene is determined based on the cause of a stoppage of the mount line and the period of time elapsed since the restart. However, the scene may be defined based only on the cause of a stoppage of the mount line. That is, it is acceptable that scenes are not distinguished from each other based on the period of time elapsed since the restart. Even if this is the case, it is also possible to achieve the advantageous effect of achieving reliable product quality according to the state of the mount line. If scenes not are distinguished from each other based on the period of time, the influence of correction may be gradually reduced based on the period time elapsed since the restart. If this is the case, although the period of time elapsed since the restart is not taken into consideration regarding the definition of scenes or learning processing, the period of time elapsed since the restart can be reflected to the adjustment of the setting parameters.

Although a description has been given on the assumption that all the above-described functions are realized only with the analysis apparatus 206, the functions may be separately realized with the apparatuses included in the quality management system 200. Also, the functions of the above-described apparatuses in the quality management system 200 may be separately realized with a plurality of apparatuses.

### INDEX TO THE REFERENCE NUMERALS

101 ... Solder printing apparatus 102... Mounter 103 ... Reflow furnace
104 ... Production facility management apparatus 201 ... Solder printing inspection apparatus
202 ... Component inspection apparatus 203 ... Appearance inspection apparatus
204 ... X-ray inspection apparatus
205 ... Inspection management apparatus 206 ... Analysis apparatus 207 ... Operation terminal
11 ... Facility state acquisition unit
12 ... Scene identification unit
13 ... Learning unit
14 ... Correction function storage unit
15 ... Mount program correction unit

## Claims

1. A quality management apparatus (200) for managing a surface mount production line for performing: a solder printing step of printing solder onto a printed circuit board by using a solder printing apparatus (101); a mounting step of arranging electronic components on the printed circuit board by using a mounter (102); and a reflow step of soldering the electronic components by using a reflow furnace (103), the quality management apparatus comprising:
state acquisition means (12) adapted to acquire a state of the surface mount production line, wherein, for each of a plurality of causes of a stoppage of the surface mount production line including replacement and/or maintenance of parts of the surface mount production line, a plurality of states are defined based on a period of time elapsed since a restart of the surface mount production line, and the state acquisition means (12) is adapted to acquire the state of the surface mount production line after the restart of the surface mount production line from the states based on information of the cause of the stoppage before the restart and an operation time elapsed since the restart;
correction information storage means (14) adapted to store correction information for correcting a setting parameter for at least one of: the solder printing apparatus (101); the mounter (102); and the reflow furnace (103), for each of the states; and
correction means (15) adapted to acquire, from the correction information storage means (14), correction information that corresponds to the state acquired by the state acquisition means (12), and correcting the setting parameter for at least one of: the solder printing apparatus (101); the mounter (102); and the reflow furnace (103), using the acquired correction information.

2. The quality management apparatus (200) according to claim 1, further comprising:
learning means (13) for learning correction information for correcting a setting parameter for at least one of: the solder printing apparatus (101); the mounter (102); and the reflow furnace (103), for each state,
wherein the learning means (13) is configured to
operate the surface mount production line in a given state while changing the setting parameter,
acquire an inspection result from an inspection apparatus (205) for at least one of: the solder printing step; the mounting step; and the reflow step when operating the surface mount production line while changing the setting parameter, and
determine correction information corresponding to the state based on the inspection result, and store the correction information in the correction information storage means (14).

3. The quality management apparatus (200) according to claim 2,
wherein the learning means (13) is configured to estimate correction information for a third state that relates to a first state and a second state, based on correction information for the first state and correction state for the second state, and to store the estimated correction information in the correction information storage means (14).

4. The quality management apparatus (200) according to any one of claims 1 to 3,
wherein the correction information storage means (14) stores the correction information for each state for each component, and
the correction means (15) is configured to acquire correction information corresponding to a type of component from the correction information storage means (14), and to correct the setting parameter for at least one of: the printing apparatus (101); the mounter (102); and the reflow furnace (103).

5. The quality management apparatus (200) according to any one of claims 1 to 4, further comprising:
output means for outputting a value of the setting parameter that has been corrected or the amount of correction made to the setting parameter in a case where the correction means (15) corrects the setting parameter.

6. The quality management apparatus (200) according to claim 5,
wherein the output means is configured to output a current state of the surface mount production line as well.

7. The quality management apparatus (200) according to claim 5 or 6,
wherein the correction means (15) is configured to correct the setting parameter after acquiring a permission for correction from a user, after the outputting by the output means, or automatically correct the setting parameter.

8. The quality management apparatus (200) according to any one of claims 1 to 7,
wherein the correction means (15) is configured to correct the setting parameter by changing a mount program of at least one of: the solder printing apparatus (101); the mounter (102); and the reflow furnace (103).

9. The quality management (200) apparatus according to any one of claims 1 to 8, further comprising:
notification means for providing a notification of a failure occurrence prediction if an inspection result of a work is out of a range of normal value in a case where the correction means (15) corrects the setting parameter.

10. A quality management method for managing a surface mount production line for performing: a solder printing step of printing solder onto a printed circuit board by using a solder printing apparatus (101); a mounting step of arranging electronic components on the printed circuit board by using a mounter (102); and a reflow step of soldering the electronic components by using a reflow furnace (103), in which a computer executes:
defining for each of a plurality of causes of a stoppage of the surface mount production line including replacement and/or maintenance of parts of the surface mount production line, a plurality of states based on a period of time elapsed since a restart of the surface mount production line, and
a learning step (S13 - S17) of learning correction information for correcting a setting parameter for at least one of: the solder printing apparatus (101); the mounter (102); and the reflow furnace (103), for each state, and storing the correction information in correction information storage means (14);
a state acquisition step (S11, S22) of acquiring a state of the surface mount production line, wherein, the state acquisition step (S11, S22) acquires the state of the surface mount production line after the restart of the surface mount production line from the states based on information of the cause of the stoppage before the restart and an operation time elapsed since the restart; and
a correction step of acquiring correction information (S23) corresponding to the state acquired in the state acquisition step (S11, S22), from the correction information storage means (14), and correcting the setting parameter (S24) for at least one of: the solder printing apparatus (101); the mounter (102); and the reflow furnace (103), using the acquired correction information.

11. The quality management method according to claim 10,
wherein, in the learning step (S13 - S17),
the setting parameter is changed and the surface mount production line is operated in a given state with the changed setting parameter (S15),
an inspection result is acquired (S14, S16) from an inspection apparatus (205) for at least one of: the solder printing step; the mounting step; and the reflow step when the surface mount production line is operated with the changed setting parameter (S15), and
correction information corresponding to the state is determined based on the inspection result (S14, S16), and the correction information is stored in the correction information storage means (14).

12. The quality management method according to claim 10 or 11,
wherein the learning step (S13 - S17) is performed without the correction step (S15) being performed, and upon the learning step (S13 - S17) being completed, the correction step (S15) is performed without the learning step (S13 - S17) being performed.

13. A program for causing a computer of a surface mount production line to perform the quality management method according to any one of claims 10 to 12.

## Patentansprüche

1. Qualitätsmanagementvorrichtung (200) zum Verwalten einer Oberflächenmontage-Produktionsstraße zum Durchführen: eines Lotdruckschritts des Druckens von Lot auf eine Leiterplatte durch Verwendung einer Lotdruckvorrichtung (101); eines Montageschritts des Anordnens von elektronischen Komponenten auf der Leiterplatte durch Verwendung eines Bestückers (102); und eines Wiederaufschmelzschritts des Lötens der elektronischen Komponenten durch Verwendung eines Reflow-Ofens (103), wobei die Qualitätsmanagementvorrichtung umfasst:
ein Zustandserfassungsmittel (12), das dazu ausgebildet ist, einen Zustand der Oberflächenmontage-Produktionsstraße zu erfassen, wobei für jede von einer Vielzahl von Ursachen eines Stillstands der Oberflächenmontage-Produktionsstraße, umfassend Austausch und/oder Wartung von Teilen der Oberflächenmontage-Produktionsstraße, eine Vielzahl von Zuständen basierend auf einem seit einem Neustart der Oberflächenmontage-Produktionsstraße verstrichenen Zeitraum definiert ist und das Zustandserfassungsmittel (12) dazu ausgebildet ist, den Zustand der Oberflächenmontage-Produktionsstraße nach dem Neustart der Oberflächenmontage-Produktionsstraße basierend auf Informationen über die Ursache des Stillstands vor dem Neustart und eine seit dem Neustart verstrichene Betriebszeit aus den Zuständen zu erfassen;
ein Korrekturinformationsspeichermittel (14), das dazu ausgebildet ist, Korrekturinformationen zum Korrigieren eines Einstellparameters für mindestens eines von der Lotdruckvorrichtung (101), dem Bestücker (102) und dem Reflow-Ofen (103), für jeden der Zustände, zu speichern; und
ein Korrekturmittel (15), das dazu ausgebildet ist, Korrekturinformationen, die dem durch das Zustandserfassungsmittel (12) erfassten Zustand entsprechen, von dem Korrekturinformationsspeichermittel (14) zu holen und durch Verwendung der geholten Korrekturinformationen den Einstellparameter für mindestens eines von der Lotdruckvorrichtung (101), dem Bestücker (102) und dem Reflow-Ofen (103) zu korrigieren.

2. Qualitätsmanagementvorrichtung (200) nach Anspruch 1, ferner umfassend:
ein Lernmittel (13) zum Lernen von Korrekturinformationen zum Korrigieren eines Einstellparameters für mindestens eines von der Lotdruckvorrichtung (101), dem Bestücker (102) und dem Reflow-Ofen (103), für jeden Zustand,
wobei das Lernmittel (13) dazu ausgebildet ist,
die Oberflächenmontage-Produktionsstraße in einem bestimmten Zustand zu betreiben und dabei den Einstellparameter zu ändern,
ein Prüfergebnis von einer Prüfvorrichtung (205) für mindestens einen von dem Lotdruckschritt, dem Montageschritt und dem Wiederaufschmelzschritt zu erhalten, wenn die Oberflächenmontage-Produktionsstraße betrieben und dabei der Einstellparameter geändert wird, und
Korrekturinformationen, die dem Zustand entsprechen, basierend auf dem Prüfergebnis zu bestimmen und die Korrekturinformationen in dem Korrekturinformationsspeichermittel (14) zu speichern.

3. Qualitätsmanagementvorrichtung (200) nach Anspruch 2,
wobei das Lernmittel (13) dazu ausgebildet ist, Korrekturinformationen für einen dritten Zustand, der mit einem ersten Zustand und einem zweiten Zustand in Bezug steht, basierend auf Korrekturinformationen für den ersten Zustand und Korrekturinformationen für den zweiten Zustand zu schätzen und die geschätzten Korrekturinformationen in dem Korrekturinformationsspeichermittel (14) zu speichern.

4. Qualitätsmanagementvorrichtung (200) nach einem beliebigen der Ansprüche 1 bis 3,
wobei das Korrekturinformationsspeichermittel (14) die Korrekturinformationen für jeden Zustand für jede Komponente speichert und
das Korrekturmittel (15) dazu ausgebildet ist, Korrekturinformationen, die einem Komponententyp entsprechen, aus dem Korrekturinformationsspeichermittel (14) zu holen und den Einstellparameter für mindestens eines von der Lotdruckvorrichtung (101), dem Bestücker (102) und dem Reflow-Ofen (103) zu korrigieren.

5. Qualitätsmanagementvorrichtung (200) nach einem beliebigen der Ansprüche 1 bis 4, ferner umfassend:
ein Ausgabemittel zum Ausgeben eines Werts des Einstellparameters, der korrigiert wurde, oder des Ausmaßes der an dem Einstellparameter vorgenommenen Korrektur, in einem Fall, in dem das Korrekturmittel (15) den Einstellparameter korrigiert.

6. Qualitätsmanagementvorrichtung (200) nach Anspruch 5,
wobei das Ausgabemittel dazu ausgebildet ist, auch einen aktuellen Zustand der Oberflächenmontage-Produktionsstraße auszugeben.

7. Qualitätsmanagementvorrichtung (200) nach Anspruch 5 oder 6,
wobei das Korrekturmittel (15) dazu ausgebildet ist, den Einstellparameter nach dem Einholen einer Genehmigung zur Korrektur von einem Benutzer, nach dem Ausgeben durch das Ausgabemittel, zu korrigieren oder den Einstellparameter automatisch zu korrigieren.

8. Qualitätsmanagementvorrichtung (200) nach einem beliebigen der Ansprüche 1 bis 7,
wobei das Korrekturmittel (15) dazu ausgebildet ist, den Einstellparameter durch Ändern eines Montageprogramms von mindestens einem von der Lotdruckvorrichtung (101), dem Bestücker (102) und dem Reflow-Ofen (103) zu korrigieren.

9. Qualitätsmanagementvorrichtung (200) nach einem beliebigen der Ansprüche 1 bis 8, ferner umfassend:
ein Benachrichtigungsmittel zum Bereitstellen einer Benachrichtigung über eine Fehlerauftrittsvorhersage, wenn ein Prüfergebnis einer Arbeit außerhalb eines normalen Wertebereichs liegt, in einem Fall, in dem das Korrekturmittel (15) den Einstellparameter korrigiert.

10. Qualitätsmanagementverfahren zum Verwalten einer Oberflächenmontage-Produktionsstraße zum Durchführen:
eines Lotdruckschritts des Druckens von Lot auf eine Leiterplatte durch Verwendung einer Lotdruckvorrichtung (101); eines Montageschritts des Anordnens von elektronischen Komponenten auf der Leiterplatte durch Verwendung eines Bestückers (102); und eines Wiederaufschmelzschritts des Lötens der elektronischen Komponenten durch Verwendung eines Reflow-Ofens (103), wobei ein Computer ausführt:
Definieren, für jede von einer Vielzahl von Ursachen eines Stillstands der Oberflächenmontage-Produktionsstraße, umfassend Austausch und/oder Wartung von Teilen der Oberflächenmontage-Produktionsstraße, einer Vielzahl von Zuständen basierend auf einem seit einem Neustart der Oberflächenmontage-Produktionsstraße verstrichenen Zeitraum, und
einen Lernschritt (S13-S17) des Lernens von Korrekturinformationen zum Korrigieren eines Einstellparameters für mindestens eines von der Lotdruckvorrichtung (101), dem Bestücker (102) und dem Reflow-Ofen (103), für jeden Zustand, und des Speicherns der Korrekturinformationen in einem Korrekturinformationsspeichermittel (14);
einen Zustandserfassungsschritt (S11, S22) des Erfassens eines Zustands der Oberflächenmontage-Produktionsstraße, wobei der Zustandserfassungsschritt (S11, S22) den Zustand der Oberflächenmontage-Produktionsstraße nach dem Neustart der Oberflächenmontage-Produktionsstraße basierend auf Informationen über die Ursache des Stillstands vor dem Neustart und eine seit dem Neustart verstrichene Betriebszeit aus den Zuständen erfasst; und
einen Korrekturschritt des Holens von Korrekturinformationen (S23), die dem in dem Zustandserfassungsschritt (S11, S22) erfassten Zustand entsprechen, von dem Korrekturinformationsspeichermittel (14) und des Korrigierens des Einstellparameters (S24) für mindestens eines von der Lotdruckvorrichtung (101), dem Bestücker (102) und dem Reflow-Ofen (103) durch Verwendung der geholten Korrekturinformationen.

11. Qualitätsmanagementverfahren nach Anspruch 10,
wobei in dem Lernschritt (S13-S17)
der Einstellparameter geändert wird und die Oberflächenmontage-Produktionsstraße in einem bestimmten Zustand mit dem geänderten Einstellparameter betrieben wird (S15),
ein Prüfergebnis von einer Prüfvorrichtung (205) für mindestens eines von dem Lotdruckschritt, dem Montageschritt und dem Wiederaufschmelzschritt erhalten wird (S14, S16), wenn die Oberflächenmontage-Produktionsstraße mit dem geänderten Einstellparameter betrieben wird (S15), und
Korrekturinformationen, die dem Zustand entsprechen, basierend auf Prüfergebnis bestimmt werden (S14, S16) und die Korrekturinformationen in dem Korrekturinformationsspeichermittel (14) gespeichert werden.

12. Qualitätsmanagementverfahren nach Anspruch 10 oder 11,
wobei der Lernschritt (S13-S17) durchgeführt wird, ohne dass der Korrekturschritt (S15) durchgeführt wird, und nachdem der Lernschritt (S13-S17) fertiggestellt wurde, der Korrekturschritt (S15) durchgeführt wird, ohne dass der Lernschritt (S13-S17) durchgeführt wird.

13. Programm zum Bewirken, dass ein Computer einer Oberflächenmontage-Produktionsstraße das Qualitätsmanagementverfahren gemäß einem beliebigen der Ansprüche 10 bis 12 durchführt.

## Revendications

1. Appareil de gestion de qualité (200) pour gérer une ligne de production de montage en surface pour réaliser : une étape d'impression de brasure consistant à imprimer une brasure sur une carte de circuit imprimé en utilisant un appareil d'impression de brasure (101) ; une étape de montage consistant à agencer des composants électroniques sur la carte de circuit imprimé en utilisant un appareil monteur (102) ; et une étape de refusion consistant à braser les composants électroniques en utilisant un four de refusion (103), l'appareil de gestion de qualité comprenant :
un moyen d'acquisition d'état (12) adapté pour acquérir un état de la ligne de production de montage en surface, dans lequel, pour chacune d'une pluralité de causes d'un arrêt de la ligne de production de montage en surface incluant le remplacement et/ou la maintenance de pièces de la ligne de production de montage en surface, une pluralité d'états sont définis d'après une période de temps écoulée depuis un redémarrage de la ligne de production de montage en surface, et le moyen d'acquisition d'état (12) est adapté pour acquérir l'état de la ligne de production de montage en surface après le redémarrage de la ligne de production de montage en surface à partir des états d'après des informations sur la cause de l'arrêt avant le redémarrage et un temps de fonctionnement écoulé depuis le redémarrage ;
un moyen de stockage d'informations de correction (14) adapté pour stocker des informations de correction pour corriger un paramètre de réglage pour au moins l'un parmi : l'appareil d'impression de brasure (101) ; l'appareil monteur (102) et le four de refusion (103), pour chacun des états ; et
un moyen de correction (15) adapté pour acquérir, à partir du moyen de stockage d'informations de correction (14), des informations de correction qui correspondent à l'état acquis par le moyen d'acquisition d'état (12), et corriger le paramètre de réglage pour au moins l'un parmi : l'appareil d'impression de brasure (101) ; l'appareil monteur (102) et le four de refusion (103), à l'aide des informations de correction acquises.

2. Appareil de gestion de qualité (200) selon la revendication 1, comprenant en outre :
un moyen d'apprentissage (13) pour apprendre des informations de correction pour corriger un paramètre de réglage pour au moins l'un parmi : l'appareil d'impression de brasure (101) ; l'appareil monteur (102) et le four de refusion (103), pour chaque état,
dans lequel le moyen d'apprentissage (13) est configuré pour
faire fonctionner la ligne de production de montage en surface dans un état donné tout en changeant le paramètre de réglage,
acquérir un résultat d'inspection à partir d'un appareil d'inspection (205) pour au moins l'une parmi : l'étape d'impression de brasure ; l'étape de montage ; et l'étape de refusion lors du fonctionnement de la ligne de production de montage en surface tout en changeant le paramètre de réglage, et
déterminer des informations de correction correspondant à l'état d'après le résultat d'inspection, et stocker les informations de correction dans le moyen de stockage d'informations de correction (14).

3. Appareil de gestion de qualité (200) selon la revendication 2,
dans lequel le moyen d'apprentissage (13) est configuré pour estimer des informations de correction pour un troisième état qui est lié à un premier état et un deuxième état, d'après des informations de correction pour le premier état et un état de correction pour le deuxième état, et pour stocker les informations de correction estimées dans le moyen de stockage d'informations de correction (14).

4. Appareil de gestion de qualité (200) selon l'une quelconque des revendications 1 à 3,
dans lequel le moyen de stockage d'informations de correction (14) stocke les informations de correction pour chaque état pour chaque composant, et
le moyen de correction (15) est configuré pour acquérir des informations de correction correspondant à un type de composant à partir du moyen de stockage d'informations de correction (14), et pour corriger le paramètre de réglage pour au moins l'un parmi : l'appareil d'impression (101) ; l'appareil monteur (102) et le four de refusion (103).

5. Appareil de gestion de qualité (200) selon l'une quelconque des revendications 1 à 4, comprenant en outre :
un moyen de sortie pour fournir en sortie une valeur du paramètre de réglage qui a été corrigé ou la quantité de correction apportée au paramètre de réglage dans un cas où le moyen de correction (15) corrige le paramètre de réglage.

6. Appareil de gestion de qualité (200) selon la revendication 5,
dans lequel le moyen de sortie est configuré pour également fournir en sortie un état actuel de la ligne de production de montage en surface.

7. Appareil de gestion de qualité (200) selon la revendication 5 ou 6,
dans lequel le moyen de correction (15) est configuré pour corriger le paramètre de réglage après l'acquisition d'une permission de correction provenant d'un utilisateur, après la fourniture en sortie par le moyen de sortie, ou pour corriger automatiquement le paramètre de réglage.

8. Appareil de gestion de qualité (200) selon l'une quelconque des revendications 1 à 7,
dans lequel le moyen de correction (15) est configuré pour corriger le paramètre de réglage en changeant un programme de montage d'au moins l'un parmi : l'appareil d'impression de brasure (101) ; l'appareil monteur (102) et le four de refusion (103).

9. Appareil de gestion de qualité (200) selon l'une quelconque des revendications 1 à 8, comprenant en outre :
un moyen de notification pour fournir une notification d'une prédiction de survenue de défaillance si un résultat d'inspection d'un travail est en dehors d'une plage de valeurs normales dans un cas où le moyen de correction (15) corrige le paramètre de réglage.

10. Méthode de gestion de qualité pour gérer une ligne de production de montage en surface pour réaliser : une étape d'impression de brasure consistant à imprimer une brasure sur une carte de circuit imprimé en utilisant un appareil d'impression de brasure (101) ; une étape de montage consistant à agencer des composants électroniques sur la carte de circuit imprimé en utilisant un appareil monteur (102) ; et une étape de refusion consistant à braser les composants électroniques en utilisant un four de refusion (103), dans laquelle un ordinateur exécute :
la définition, pour chacune d'une pluralité de causes d'un arrêt de la ligne de production de montage en surface incluant le remplacement et/ou la maintenance de pièces de la ligne de production de montage en surface, d'une pluralité d'états d'après une période de temps écoulée depuis un redémarrage de la ligne de production de montage en surface, et
une étape d'apprentissage (S13 à S17) consistant à apprendre des informations de correction pour corriger un paramètre de réglage pour au moins l'un parmi : l'appareil d'impression de brasure (101) ; l'appareil monteur (102) et le four de refusion (103), pour chaque état, et à stocker des informations de correction dans un moyen de stockage d'informations de correction (14) ;
une étape d'acquisition d'état (S11, S22) consistant à acquérir un état de la ligne de production de montage en surface, dans laquelle l'étape d'acquisition d'état (S11, S22) acquiert l'état de la ligne de production de montage en surface après le redémarrage de la ligne de production de montage en surface à partir des états d'après des informations sur la cause de l'arrêt avant le redémarrage et un temps de fonctionnement écoulé depuis le redémarrage ; et
une étape de correction consistant à acquérir des informations de correction (S23) correspondant à l'état acquis à l'étape d'acquisition d'état (S11, S22), à partir du moyen de stockage d'informations de correction (14), et à corriger le paramètre de réglage (S24) pour au moins l'un parmi : l'appareil d'impression de brasure (101) ; l'appareil monteur (102) et le four de refusion (103), à l'aide des informations de correction acquises.

11. Méthode de gestion de qualité selon la revendication 10,
dans laquelle, à l'étape d'apprentissage (S13 à S17),
le paramètre de réglage est changé et la ligne de production de montage en surface fonctionne dans un état donné avec le paramètre de réglage changé (S15),
un résultat d'inspection est acquis (S14, S16) à partir d'un appareil d'inspection (205) pour au moins l'une parmi : l'étape d'impression de brasure ; l'étape de montage et l'étape de refusion lorsque la ligne de production de montage en surface fonctionne avec le paramètre de réglage changé (S15), et
des informations de correction correspondant à l'état sont déterminées d'après le résultat d'inspection (S14, S16), et les informations de correction sont stockées dans le moyen de stockage d'informations de correction (14).

12. Méthode de gestion de qualité selon la revendication 10 ou 11,
dans laquelle l'étape d'apprentissage (S13 à S17) est réalisée sans que l'étape de correction (S15) soit réalisée, et lors de l'achèvement de l'étape d'apprentissage (S13 à S17), l'étape de correction (S15) est réalisée sans que l'étape d'apprentissage (S13 à S17) soit réalisée.

13. Programme pour amener un ordinateur d'une ligne de production de montage en surface à réaliser la méthode de gestion de qualité selon l'une quelconque des revendications 10 à 12.
